# EUROPEAN PATENT SPECIFICATION

(11) **EP 3 388 545 B1**
(45) Date of publication and mention of the grant of the patent: **11.03.2020**
(21) Application number: 18166493.9
(22) Date of filing: 10.04.2018
(51) Int. Cl.: C23C 10/04, C23C 28/02, F01D 5/00, B23P 6/00

(54) **REPAIRED AIRFOIL WITH IMPROVED COATING SYSTEM AND METHODS OF FORMING THE SAME**
REPARIERTES SCHAUFELBLATT MIT VERBESSERTEM BESCHICHTUNGSSYSTEM UND VERFAHREN ZUR HERSTELLUNG DAVON
SURFACE PORTANTE RÉPARÉE MUNIE D'UN SYSTÈME DE REVÊTEMENT AMÉLIORÉ ET SES PROCÉDÉS DE FORMATION

(30) Priority: 13.04.2017 US 201715486507
(43) Date of publication of application: 17.10.2018
(73) Proprietor: General Electric Company, Schenectady, NY 12345 (US)
(72) Inventor: NAGARAJ, Bangalore Aswatha, Cincinnati, OH Ohio 45215 (US)
(74) Representative: Openshaw & Co.

(56) References cited:
- EP-A1- 0 587 341
- EP-A1- 0 992 614
- EP-A2- 2 191 930
- WO-A1-2006/071507

## Description

### FIELD

The present invention generally relates to protective coatings on components, and, more particularly, to NiCoCrAlY and platinum-group metal aluminide coatings on gas turbine components having airfoils.

### BACKGROUND

In gas turbine engines, air is drawn into the front of the engine, compressed by a shaft-mounted compressor, and mixed with fuel. The mixture is combusted, and the resulting hot combustion gases are passed through a turbine mounted on the same shaft. The flow of gas turns the turbine by contacting an airfoil portion of the turbine blade, which turns the shaft and provides power to the compressor. The hotter the turbine gases, the more efficient the operation of the engine. Thus, there is an incentive to raise the turbine operating temperature. However, the maximum temperature of the turbine gases is normally limited by the materials used to fabricate the turbine vanes and turbine blades of the turbine.

A protective layer is applied to the airfoil of the turbine blade or turbine vane component, which acts as a substrate. Among the currently known diffusional protective layers are aluminide and platinum aluminide layers. The protective layer protects the substrate against environmental damage from the hot, highly corrosive combustion gases. This protective coating is approximately 38 µm to 76 µm (i.e., approximately 0.0015 to 0.0030 inch) thick, and provides a degree of protection against marine hot corrosion. Approximately half the thickness of the diffusion coating is part of the original blade thickness & the diffusion platinum aluminide coatings are effective in maintaining the cooling holes open after the coating process. Even with the use of these protective techniques, there remain problems to overcome in certain operating service conditions, particularly within marine turbine engines that are exposed to harsh conditions related to the salinity of the operating environments.

A more effective alternative coating, which is used widely in marine gas turbine applications, is approx. 254 µm (i.e., about 0.010 inch) with an "overlay" MCrAlX coating having a thickness range of about 177.8 µm to about 330 µm (i.e., about 0.07 inch to about 0.013 inch), where M is (Co and/or Ni), X is a reactive element such as Y, Hf, and the coating has a chromium concentration of 20% to 28%. The overlay coatings are typically deposited by a plasma spray process, and the composition of the coating can be tailored to mitigate marine hot corrosion.

EP 2 191 930 A discloses a method for repairing a metallic turbine component having holes and made from a nickel-based superalloy which includes applying a new metallic bond coat to the turbine component. The bond coat may comprise a layer of MCrAlX consisting essentially of, by mass, about 18 % chromium, 10 % cobalt, 6.5 % aluminum, 2 % rhenium, 6 % tantalum, 0.5 % hafnium, 0.3 % yttrium, 1 % silicon, 0.015 % zirconium, 0.06 % carbon and 0.015 % boron, the balance nickel; and a Pt-modified nickel aluminide layer.

However, the maximum temperature of the turbine gases is normally limited by the materials used to fabricate the turbine vanes and turbine blades of the turbine. Advanced turbine blades are cooled by cooling air from compressor discharge to reduce the blade temperature and enable a higher gas temperature for increased efficiency. Thus, it is important to keep the cooling holes open to prevent overheating of blades.

For gas turbines operating in marine environment, it is necessary for the coatings to resist corrosive attack from environmental corrodents. Deposits containing sodium sulfate have been recognized to be particularly corrosive to marine airfoils.

Cobalt based CoCrAlHf coatings with chromium content in the range of 20 to 25%, aluminum in the range of 9 to 11% have been utilized successfully to resist marine corrosion. The coatings are thick (relative to the size of cooling holes of advanced turbine blades), typically in the range of 177.8 µm to about 356 µm (i.e., about 0.07 inch to about 0.014 inch) and are deposited by a thermal spray process. Such coatings are deposited on new blades prior to drilling of holes, since the coatings can partially or completely close the holes during their application.

When the field returned blades are ready for repair, any and all the remaining CoCrAlHf coating is stripped off with an appropriate acid. Some manufactures require chemical cleaning with strong acid or alkali mixtures to remove field service debris and/or hot corrosion products prior to stripping. Others allow grit blasting to accomplish the same ends. Complex cooling passages in blades can accumulate dust or other debris in service, which may have to be removed with hot caustic at elevated pressure in an autoclave.

Full removal of coatings is universally accomplished by selective dissolution of the coating phase(s) by various simple or complex mixture of acids. Most procedures depend on selective attack of beta (NiAl or CoAl) phases. If coatings are depleted of beta phases, selective coating dissolution can be difficult or impossible, and residual coatings must then be removed by physical methods (e.g., belt grinding).

Re-coating of repaired blades with cooling holes is typically accomplished a diffusion aluminide or platinum aluminide process, (described above) which keeps the cooling holes open. Platinum aluminide is a diffusion coating, the composition and properties of the platinum aluminide coating depend, in part, on the chemistry of the underlying alloy or coating. It is necessary to remove all the original CoCrAlHf coatings, since platinum aluminide coating of any underlying CoCrAlHf coating will result in a brittle cobalt platinum aluminide, which is undesirable. Since the diffusion platinum aluminide coatings are relatively thin and have a composition that is rich in nickel, but deficient in chromium and cobalt, the marine hot corrosion resistance of platinum aluminide coating is inferior to that provided by the thicker CoCrAlHf coatings.

Thus, an improved method of repair such coatings is generally needed, particularly with gas turbine components used in marine environments.

### BRIEF DESCRIPTION

Objects and advantages of the invention will be set forth in part in the following description, or may be obvious from the description, or may be learned through practice of the invention.

A method is generally provided of forming a coating system on a surface of a superalloy component having film holes defined therein. In one embodiment, the method includes applying NiCoCrAlY on the surface of the superalloy component to form a NiCoCrAlY layer while keeping the film holes open (e.g., wherein the NiCoCrAlY layer has a chromium content that is higher than the superalloy component), then heating the NiCoCrAlY layer to a treatment temperature of about 900 °C to about 1200 °C, then forming a platinum-group metal layer on the NiCoCrAlY layer, and then forming an aluminide coating over platinum-group metal layer.

In one particular aspect, the NiCoCrAlY is applied onto an existing coating system on the surface of the superalloy component, wherein the existing coating system is a Co-based coating system that is substantially free from Ni.

Other features and aspects of the present invention are discussed in greater detail below.

### BRIEF DESCRIPTION OF THE DRAWINGS

The invention may be best understood by reference to the following description taken in conjunction with the accompanying drawing figures in which:
FIG. 1A is a perspective view of an component, such as a turbine blade of a gas turbine engine;
FIG. 1B is a perspective view of another component, such as a nozzle segment of a gas turbine engine;
FIG. 2 is a cross-sectional view of an exemplary NiCoCrAlY layer on a surface of a component, such as the airfoil of FIG. 1A or FIG. 1B, prior to heat treatment;
FIG. 3 is a cross-sectional view of an exemplary coating system including the NiCoCrAlY layer after heat treatment and forming a platinum aluminide coating thereon;
FIG. 4 is a cross-sectional view of the exemplary coating system of FIG. 3, with a TBC coating thereon;
FIG. 5 is a block diagram of an exemplary method of forming a coating on a surface of a component; and
FIG. 6 is a block diagram of an exemplary method of repairing a coating on a surface of a component.

Repeat use of reference characters in the present specification and drawings is intended to represent the same or analogous features or elements of the present invention.

### DETAILED DESCRIPTION

Reference now will be made to the embodiments of the invention, one or more examples of which are set forth below. Each example is provided by way of an explanation of the invention, not as a limitation of the invention. In fact, it will be apparent to those skilled in the art that various modifications and variations can be made in the invention without departing from the scope of the invention. For instance, features illustrated or described as one embodiment can be used on another embodiment to yield still a further embodiment. Thus, it is intended that the present invention cover such modifications and variations as come within the scope of the appended claims. It is to be understood by one of ordinary skill in the art that the present discussion is a description of exemplary embodiments only, and is not intended as limiting the broader aspects of the present invention, which broader aspects are embodied exemplary constructions.

Chemical elements are discussed in the present disclosure using their common chemical abbreviation, such as commonly found on a periodic table of elements. For example, hydrogen is represented by its common chemical abbreviation H; helium is represented by its common chemical abbreviation He; and so forth.

A coating system is generally provided for hot gas path components (e.g., airfoils) of turbine engines, along with methods of its formation. In particular, the coating system is useful on a superalloy component of a marine turbine engine, which is exposed to particularly corrosive operating environments. The methods and coating system is particularly useful during a repair of a component that has been used and damaged during use, either through an impact event or corrosion. Embodiments of the methods described herein leads to enhancement of the corrosion resistance of the existing coating by incorporating chromium and cobalt while keeping the cooling holes open. In one embodiment, the methods described herein allows for the retention of an existing marine Co-based coating system (e.g., a CoCrAlHf type coating that is substantially free from Ni) on surface of the used airfoil (or on the surface of a new airfoil), by adding the NiCoCrAlY materials. The resulting coating, with the platinum aluminide coatings thereon, may be thicker, less brittle, and may have a higher quantity of aluminum, leading to more resistance to oxidation than platinum aluminide on a cobalt-based material, due to the relatively lower diffusion of aluminum and platinum in a cobalt based material.

The coating system has a multiple layer construction chemistry, which includes at least a NiCoCrAlY layer, which may have a chromium (Cr) content that is higher than the underlying superalloy. The coating system is, in one particular embodiment, formed from a NiCoCrAlY layer and a platinum-group metal aluminide coating through a diffusion coating process, resulting in a coating system that includes NiCoCrAlY, Pt, and Al. The NiCoCrAlY layer has a chromium content that is higher than the superalloy component, both in its deposition composition and its composition following treatment.

The coating system can reduce the susceptibility of gas turbine components to property degradation such as low-cycle fatigue failures, while retaining the benefits associated with protective coatings that are applied to the components. The present approach may be accomplished as part of the normal production operation, without major modifications. Additionally, the use of any additional bond coating or other layer between the surface of the component and the coating system and/or within the construction of the coating system (e.g., between the NiCoCrAlY layer and the platinum-group metal aluminide coating) can be avoided in particular embodiments. That is, in this embodiment, the NiCoCrAlY layer is directly on the surface of the component, and/or the platinum-group metal aluminide coating is directly on the NiCoCrAlY layer to form the coating system. When a thermal barrier coating is present, the coating system is free from a bond coating between the NiCoCrAlY layer (e.g., the platinum-group metal aluminide coating of the coating system) and the thermal barrier coating (e.g., the thermal barrier coating is directly on the platinum-group metal aluminide coating of the coating system).

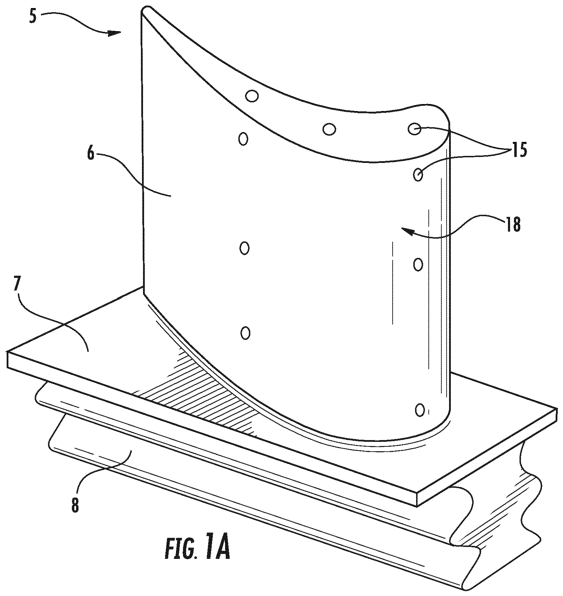

Referring to the drawings, FIG. 1A depicts an exemplary component 5 of a gas turbine engine, illustrated as a gas turbine blade. The turbine blade 5 includes an airfoil 6, a laterally extending platform 7, an attachment 8 in the form of a dovetail to attach the gas turbine blade 5 to a turbine disk (not shown). In some components, a number of cooling channels extend through the interior of the airfoil 6, ending in openings 15 in the surface of the airfoil 6. The openings 15 may be, in particular embodiments, film holes.

High pressure gas turbine blades, such as shown in FIG. 1A, operating at high temperatures & pressures and carrying load, have requirements for mechanical properties. To meet these requirements, advanced high pressure blades are manufactured from nickel-based superalloys, whose hot corrosion resistance is not ideal. Blade tips do not carry the same load and do not have the same mechanical property requirements. During repair, and in new make blades, marine gas turbine blade tips are manufactured from a corrosion resistant cobalt based material such as HS188, which contains a high chromium concentration. While a platinum aluminide coating alone on such a Co-based tip material can result in a brittle coating, the presently provided coating system (including NiCoCrAlY, Pt, and Al) provides a superior combination of oxidation resistance, corrosion resistance, and mechanical properties to the tip coating.

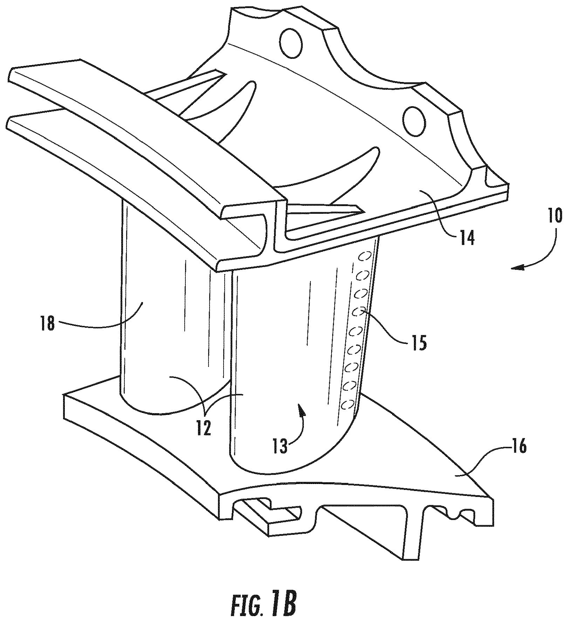

FIG. 1B represents a nozzle segment 10 that is one of a number of nozzle segments that when connected together form an annular-shaped nozzle assembly of a gas turbine engine. The segment 10 is made up of multiple vanes 12, each defining an airfoil and extending between outer and inner platforms (bands) 14 and 16. The vanes 12 and platforms 14 and 16 can be formed separately and then assembled, such as by brazing the ends of each vane 12 within openings defined in the platforms 14 and 16. Alternatively, the entire segment 10 can be formed as an integral casting. The vanes 12 generally have a leading edge 18, a trailing edge, a pressure side (i.e., the concave side), and a suction side (i.e., the convex side). The leading edge 18 is at times described as being defined by the most forward point (nose) of the airfoil 12.

When the nozzle segment 10 is assembled with other nozzle segments to form a nozzle assembly, the respective inner and outer platforms of the segments form continuous inner and outer bands between which the vanes 12 are circumferentially spaced and radially extend. Construction of a nozzle assembly with individual nozzle segments is often expedient due to the complexities of the cooling schemes typically employed. The nozzle segment 10 depicted in FIG. 1B is termed a doublet because two vanes 12 are associated with each segment 10. Nozzle segments can be equipped with more than two vanes, e.g., three vanes (termed a triplet), four vanes, six vanes, or with a single vane to form what is termed a singlet. As known in the art, the design choice between singlet and doublet castings takes into consideration the advantages associated with their different constructions and processing. A significant advantage of singlet nozzle construction is the capability for excellent coating thickness distribution around the vanes 12, which in addition to promoting oxidation and corrosion resistance also promotes control of the throat area between nozzles and uniformity between vanes of different stages. On the other hand, a doublet casting avoids the necessity for a high temperature braze operation, though with less control of coating thickness.

In one embodiment, the airfoil 6 of the turbine blade 5 of FIG. 1A and the vanes 12 of the nozzle segment 10 of FIG. 1B are located in the turbine section of the engine and are subjected to the hot combustion gases from the engine's combustor. In addition to forced air cooling techniques (e.g., via film holes 15), the surfaces of these components are protected by a coating system 22 on their respective surfaces.

The airfoil 6 of the turbine blade 5 of FIG. 1A and the vanes 12 of the nozzle segment 10 of FIG. 1B can be formed of a material that can be formed to the desired shape and withstand the necessary operating loads at the intended operating temperatures of the area of the gas turbine in which the segment will be installed. Examples of such materials include metal alloys that include, but are not limited to, titanium-, aluminum-, cobalt-, nickel-, and steel-based alloys. In one particular embodiment, the airfoil 6 of FIG. 1A and/or the vanes 12 of FIG. 1B are formed from a superalloy metal material, such as a nickel-based superalloy, a cobalt-based superalloy, or an iron-based superalloy. In typical embodiments, the superalloy component has a 2-phase structure of fine γ-(M) (face-center cubic) and β-(M)Al (body-center cubic). The β-(M)Al phase is the aluminum (Al) reservoir. Aluminum near the surface may be depleted during service by diffusion to the TBC interface forming α-Al₂O₃ thermally grown oxide on the surface of the diffusion coated substrate.

Although described above and in FIGS. 1A and 1B with respect to the turbine blade 5 and the nozzle segment 10, the coating system can be utilized with any component of the gas turbine engine.

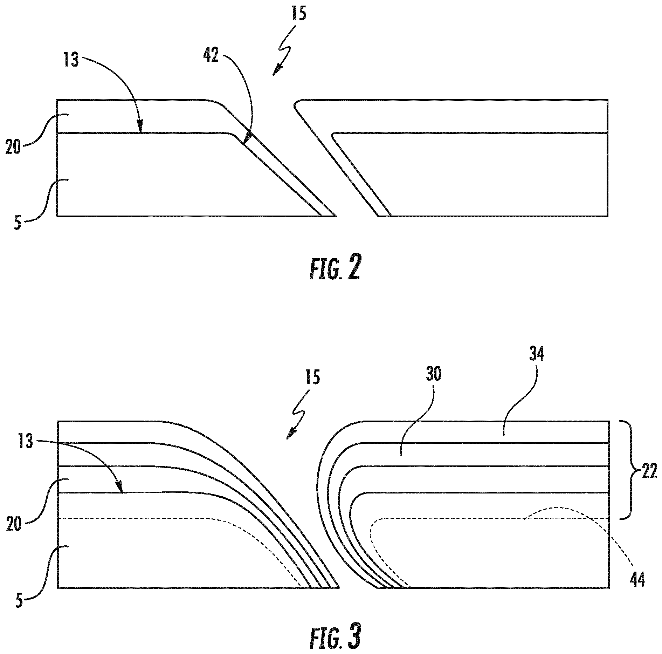

Referring to FIG. 2, a NiCoCrAlY layer 20, prior to heat treatment, is shown deposited on the surface 13 of the superalloy component 5 (e.g., an airfoil 12, as shown in FIGS. 1A and 1B). As shown, the component 5 defines a film hole 15 therethrough. As shown, the NiCoCrAlY layer 20 is formed to a thickness that does not close the film hole 15. In certain embodiments, the NiCoCrAlY layer 20 may extend into the inner surface 42 defining the film hole 15within the component 5. For example, the NiCoCrAlY layer 20 may formed via ion plasma deposition, without making the film holes 15. However, any suitable application method can be utilized to form the NiCoCrAlY layer 20, which may be utilized with or without masking techniques when desired. Non-limiting examples include plasma deposition (for example, ion plasma deposition, vacuum plasma spraying (VPS), low pressure plasma spray (LPPS), and plasma-enhanced chemical-vapor deposition (PECVD)), high velocity oxygen fuel (HVOF) techniques, high-velocity air-fuel (HVAF) techniques, physical vapor deposition (PVD), electron beam physical vapor deposition (EBPVD), chemical vapor deposition (CVD), air plasma spray (APS), cold spraying, and laser ablation. In one embodiment, the MCrAlY layer 20 is applied by a thermal spray technique (for example, VPS, LPPS, HVOF, HVAF, APS, and/or cold-spraying).

Generally, the NiCoCrAlY layer has a composition of (by weight) that is based on nickel (Ni), which provides a good surface for subsequent PtAl deposition. Cobalt (Co) is present in the NiCoCrAlY layer to interact and bond with the Co remaining on the surface from the previous coating, which may still be present on the surface or may have diffused into the surface. In one particular embodiment, the NiCoCrAlY layer has a composition at deposition (i.e., prior to heat treatment and prior to forming additional layers thereon) that includes, by weight percent, about 16% to about 20% Cr (e.g., about 17% to about 19% Cr), about 9% to about 11% Al (e.g., about 9.5% to about 10.5% Al), about 19% to about 24% Co (e.g., about 21% to about 23% Co), about 0.05% to about 0.2% Y (e.g., about 0.07% to about 0.15% Y), up to about 0.5% Hf (e.g., about 0.05% to about 0.3% Hf, such as about 0.05% to about 0.2% Hf), up to about 1% Si (e.g., about 0.5% to about 0.9% Si, such as about 0.6% to about 0.8% Si), and the balance Ni.

Following deposition, the NiCoCrAlY layer 20 is heated to bond the NiCoCrAlY layer 20 onto the surface 13 of the component 5. In one embodiment, a portion of the NiCoCrAlY layer 20 diffuses into the component 5 to form a diffused portion 44. In one embodiment, the NiCoCrAlY layer 20 is heated to a treatment temperature of about 900 °C to about 1200 °C (e.g., about 1000 °C to about 1100 °C). The NiCoCrAlY layer 20 may be heated to the treatment temperature for a time sufficient to bond the NiCoCrAlY layer 20 onto the surface 13, such as for about 30 minutes to about 5 hours.

As stated, the NiCoCrAlY layer 20 may diffuse into the component 5 due to the heat treatment to form the diffused portion 44. In one embodiment, about 30% or less of the deposited thickness of the NiCoCrAlY layer 20 diffuses into the surface 13 of the component 5, such as about 5% to about 25% of the deposited thickness may diffuse into the component 5. Following heat treatment, the NiCoCrAlY layer 20 has a thickness extending from the surface 13 that is about 10 µm to about 100 µm (e.g., about 25 µm to about 50 µm). By keeping the NiCoCrAlY layer 20 relatively thin (i.e., less than 100 µm), any film holes defined within the surface can remain open even without the use of mask or other deposition blocking method.

Examples of deposition processes which can be used to deposit NiCoCrAlY layer without closing cooling holes, and resulting in a smooth coating (e.g., having a surface roughness of about 100 µm or less) include ion plasma deposition process, composite plating process, cold spray process, high velocity air plasma spray process.

Following heat treatment, a platinum-group metal layer 30 and an aluminide coating 34 may be formed onto the NiCoCrAlY layer 20, as shown in FIG. 3. First, the platinum-group metal layer 30 is deposited on the NiCoCrAlY layer 20. The platinum-group metal layer 30 generally includes platinum, rhodium, palladium, ruthenium, osmium, iridium, or a mixture thereof. These elements have similar physical and chemical properties and tend to occur together in the same mineral deposits. In one embodiment, the palladium-group platinum-group metals (i.e., platinum, rhodium, palladium, or a mixture thereof) are included in the platinum-group metal layer 30. In one particular embodiment, the platinum-group metal layer 30 generally includes platinum, but may also include other elements (e.g., palladium and/or rhodium). For example, the platinum-group metal layer 30 can include a platinum-palladium alloy, a platinum-rhodium alloy, or a platinum-palladium-rhodium alloy. In one embodiment, platinum-group metal layer 30 includes platinum in at least 50% by weight (e.g., about 75% to 100% by weight).

In most embodiments, a suitable thickness for a platinum-group metal layer 30 is about 1 µm to about 10 µm (e.g., about 3 µm to about 7 µm). In the embodiment shown, the platinum-group metal layer 30 is formed directly on the NiCoCrAlY layer 20 due to this relatively thin nature of the platinum-group metal layer. As such, no other layer (e.g., a bond coating) is positioned between the NiCoCrAlY layer 20 and the platinum-group metal layer 30.

The platinum-group metal layer 30 can be formed via any suitable process. For example, the platinum-group metal layer 30 is, in one particular embodiment, deposited by an electrodeposition process as (e.g., electroplating), although sputtering, brush plating, etc. could alternatively be used. Plating can be performed at room temperature (e.g., about 20 °C to about 25 °C). In one embodiment, the electrodeposition process is accomplished by placing a platinum-group metal-containing solution (e.g., platinum-containing solution) into a deposition tank and depositing platinum-group metal from the solution onto the NiCoCrAlY layer 20. For example, when depositing platinum, the platinum-containing aqueous solution can include Pt(NH₃)₄ HPO₄, and the voltage/current source can be operated at about 1/2-10 amperes per square foot of facing article surface. In the deposition, the platinum-group metal layer 30 is deposited onto the unmasked portion of the surface 13 (i.e., the trailing edge 24).

The platinum-group metal layer 30 may be heat treated, as desired. For example, the platinum-group metal layer 30 can be heat treated at a treatment temperature of about 900 °C to about 1200 °C. In one embodiment, the platinum-group metal layer 30 is heat treated in a vacuum (e.g., at a treatment pressure of about 10 torr or less, such as at a treatment pressure of about 1 torr or less).

An oxidation-resistant coating is applied to the surface 13 of the airfoil 12 to further promote the oxidation resistance. In one particular embodiment, the oxidation-resistant coating is a diffusion aluminide coating 34, which may include aluminum intermetallics, gamma phase, gamma prime phase, or the like. The aluminide coating 34 is deposited overlying the platinum-group metal layer 30. The aluminide coating 34 can be formed to a thickness of about 2 µm to about 100 µm (e.g., about 25 µm to about 100 µm, such as about 35 µm to about 75 µm) by any suitable method. For example, the aluminide coating 34 can be deposited by any operable approach, such as aluminiding by pack cementation, or other processes including vapor phase aluminiding.

In one embodiment, the aluminide coating 34 is deposited via vapor phase aluminiding. For example, a hydrogen halide gas, such as hydrogen chloride or hydrogen fluoride, is contacted with aluminum metal or an aluminum alloy to form the corresponding aluminum halide gas. Other elements may be doped into the aluminum layer from a corresponding gas, if desired. The aluminum halide gas contacts the surface 13, depositing the aluminum thereon. The deposition occurs at elevated temperature such as from about 900 °C to about 1125 °C during a cycle time (e.g., a 4 to 20 hour cycle). The aluminide coating 34 is preferably from about 12 to about 125 micrometers thick (such as about 25 µm to about 100 µm, for example about 35 µm to about 75 µm). The deposition technique allows alloying elements to be co-deposited into the aluminide coating 34 if desired, from the halide gas.

Because the deposition of aluminum is performed at elevated temperature, the deposited aluminum atoms interdiffuse with the platinum-group metal layer 30 (or interdiffused platinum/substrate region) and/or the material of the NiCoCrAlY layer 20 forming a coating system 22 on the surface 13 of the component 5.

In the embodiment shown in FIG. 3, the aluminide coating 34 is deposited on the entire surface 13, within any cavities and any film holes present in the surface 13, and over the platinum-group metal layer 30. During processing, the aluminide coating reacts with the platinum-group metal layer 30 to form a platinum-group metal aluminide coating 31. This platinum-group metal aluminide coating 31 comprises the platinum-group metal and aluminum, such as platinum-modified aluminides (PtAl), but may contain additional components (e.g., platinum-modified nickel aluminides. Thus, the platinum-group metal plating, followed by diffusion aluminide, results in a "platinum aluminide layer" where its outer layer of the coating has the platinum-group metal (e.g., platinum), in addition to diffusion aluminide. In one embodiment, a second heat treatment is performed in vacuum at a treatment temperature of about 975 °C to about 1125 °C (e.g., for a treatment period of about 1 to about 4 hours).

Following heat treatment of the platinum-group metal layer 30 and the aluminide coating 34 shown in Fig. 3, the coating system 22 may have a compositional gradient throughout its thickness. For example, the resulting heat treated coating system 22 may include an inner portion adjacent to the component, a middle portion, and an outer portion opposite from the component, with each of the inner portion, the middle portion, and the outer portion defining a third (i.e., 1/3) of the thickness of the coating system 22. The coating system 22, in one embodiment, has a compositional gradient with the outer portion having a relatively low concentration of Cr and relatively high concentrations of Pt and Al, when compared to the composition of the middle portion and the inner portion. As such, outer portion has good oxidation qualities and adherence to TBC (if present thereon). However, an increased concentration of Cr in the middle portion 31 and/or the inner portion 21 can allow for increased corrosion resistance, which is particularly useful in marine and industrial engine applications.

In one particular embodiment, the outer portion has a nickel (Ni) content that is higher, in terms of weight percent, than the nickel content of the middle portion 31. Similarly, the inner portion has a nickel content that is higher, in terms of weight percent, than the nickel content of the middle portion. As such, the middle portion has a nickel content that this less than, in terms of weight percent, than the inner portion and/or the outer portion. In certain embodiments, for example, the outer portion has a nickel content of about 40% to about 50% by weight; the middle portion has a nickel content of about 30% to about 40% by weight; and the inner portion has a nickel content of greater than about 40% (e.g., greater than about 50%) by weight.

The coating system 22 is deposited and processed to have a smooth surface finish, e.g., about 3 µm or less of surface roughness (Ra), in order to promote the aerodynamics of the nozzle assembly. In one embodiment, the coating system 22 preferably has a surface roughness (Ra) of less than about 3 µm (e.g., about 0.75 µm to about 2.75 µm, such as about 1.25 µm to about 2.25 µm).

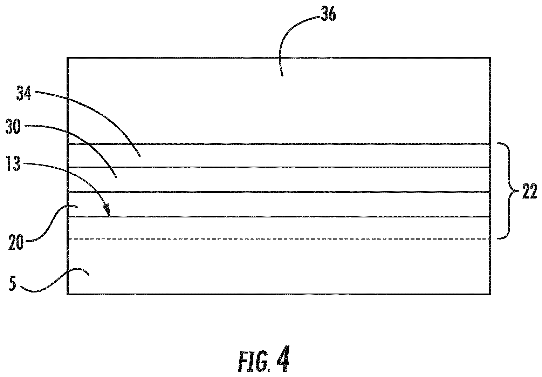

FIG. 4 also shows an environmental coating 36 (e.g., a thermal barrier coating (TBC)) over the coating system 22, which is particularly useful if further protection is required (e.g., on the surface of an airfoil 12 to be used at very high temperatures). In particular embodiments, the environmental coating 36 may also be deposited on the surfaces of the inner bands and outer bands. For example, the thermal barrier coating 36 may be entirely composed of one or more ceramic compositions. The environmental coating 36 may be applied by any operable technique, with electron beam physical vapor deposition (EB-PVD) being preferred for the preferred yttria-stabilized zirconia coating. The EB-PVD processing may be preceded and/or followed by high-temperature processes that may affect the distribution of elements in the bond coat. The EB-PVD process itself is typically conducted at elevated temperatures. Other coatings, coating compositions, and coating thicknesses are also within the scope of the invention.

The thermal barrier coating 36 is deposited and processed to have a very smooth surface finish, e.g., about 1.5 µm Ra or less, in order to promote the aerodynamics of the nozzle assembly. In one embodiment, the thermal barrier coating 36 preferably has an as-deposited surface roughness (Ra) of less than about 3 µm. Thereafter, the surface of the environmental coating 36 preferably undergoes processing, preferably peening and then tumbling, to improve the surface finish of the environmental coating 36. Following peening and tumbling, the environmental coating 36 preferably has a surface roughness of not higher than about 2.0 µm Ra, with a typical range being about 1.3 µm to about 1.8 µm Ra on the concave surfaces and leading edges of the vanes, and about 0.5 µm to 1.0 µm Ra on the convex surfaces of the vanes.

In the embodiments shown in FIGS. 2 and 3, the coating system is substantially free from any bond coating. That is, the coating system is free from a bond coating between the NiCoCrAlY layer 20 and the surface 13 of the superalloy component 5, and the coating system 22 is free from a bond coating between the coating system 22 and the thermal barrier coating 36.

As stated, the nozzle segment can have any number of airfoils (e.g., one (a singlet), two (a doublet), four, six, etc.). Different processing methods can be utilized, depending on the number of airfoils in the nozzle segments. In most embodiment, the film holes can be formed (e.g., drilled) prior to any coating is formed, and may be masked for any subsequent coatings to be applied if desired.

The present invention is generally applicable to components that operate within environments characterized by relatively high temperatures, and particularly to nozzle segments of the type represented in FIG. 1B and therefore subjected to severe oxidizing and corrosive operating environments. It should be noted that the drawings are drawn for purposes of clarity when viewed in combination with the following description, and therefore are not intended to be to scale.

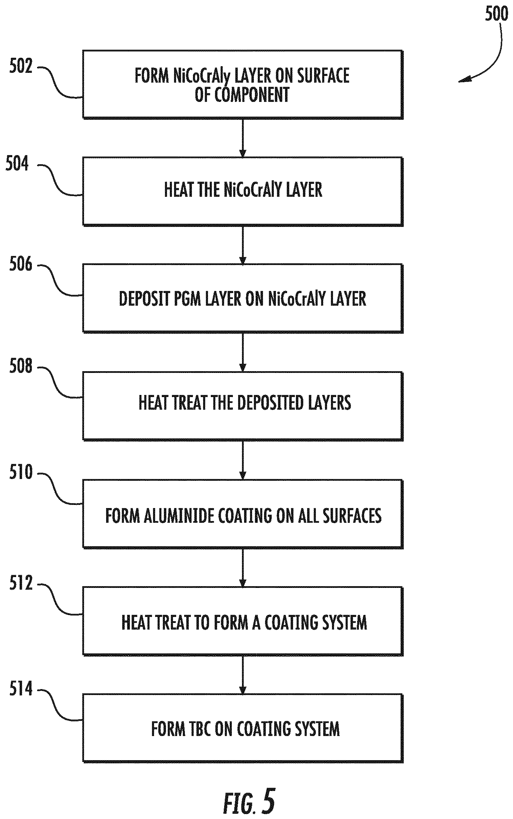

Methods are also generally provided for forming a coating on a surface of component (e.g., an airfoil) and for repairing a coating on the surface of an airfoil. Referring to Fig. 5, a diagram of an exemplary method 500 is generally shown for forming a coating on a surface of a component. At 502, a NiCoCrAlY layer is deposited on the surface of a component. The NiCoCrAlY layer is heat treated at 504, such as via heating to a treatment temperature of about 900 °C to about 1200 °C. At 506, a platinum-group metal (PGM) layer is deposited on the NiCoCrAlY layer, such as an electroplating process described above. The PGM layer is heat treated at 508, such as via heating to a treatment temperature of about 900 °C to about 1200 °C. An aluminide coating can be formed on all the surfaces at 510, such as the vapor deposition. At 512, the deposited layers can be heat treated to form a coating system. Optionally, at 514, a thermal barrier coating (TBC) can be formed over the coating system, such as through a plasma spray deposition process.

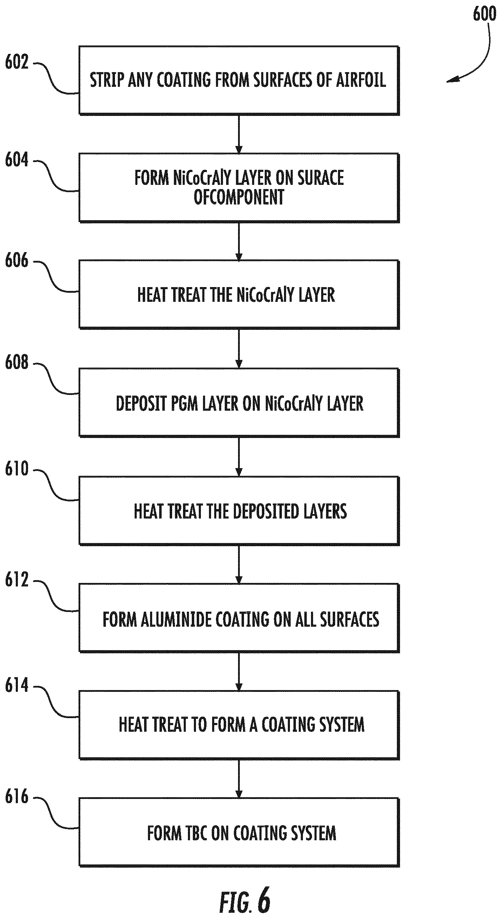

Referring to Fig. 6, a diagram of an exemplary method 600 is generally shown for repairing a coating on a surface of a component (e.g., an airfoil). At 602, any and all coatings can be stripped from the services of the airfoil, such as the chemical stripping process (e.g., acid stripping, etc.). At 604, a NiCoCrAlY layer is deposited on the surface of a component, and heat treated at 606. At 608, a platinum-group metal (PGM) layer is deposited on the MCrAlY layer, such as an electroplating process described above. The PGM layer is heat treated at 610, such as via heating to a treatment temperature of about 900 °C to about 1200 °C. An aluminide coating can be formed on all the surfaces at 612, such as the vapor deposition. At 614, the deposited layers can be heat treated to form a coating system. At 616, a thermal barrier coating (TBC) can be optionally formed over the coating system, such as through a plasma spray deposition process. Through such a repair process, the coating can be improved through the inclusion of the platinum-group metal.

These and other modifications and variations to the present invention may be practiced by those of ordinary skill in the art, without departing from the scope of the present invention, which is defined in the appended claims. In addition, it should be understood the aspects of the various embodiments may be interchanged both in whole or in part. Furthermore, those of ordinary skill in the art will appreciate that the foregoing description is by way of example only, and is not intended to limit the invention so further described in the appended claims.

## Claims

1. A method of forming a coating system (22) on a surface (13) of a superalloy component (5) having film holes (15) defined therein, the method comprising:
applying NiCoCrAlY on the surface (13) of the superalloy component (5) to form a NiCoCrAlY layer (20) while keeping the film holes (15) open, wherein the NiCoCrAlY layer (20) has a chromium content that is higher than the superalloy component (5);
thereafter, heating the NiCoCrAlY layer (20) to a treatment temperature of 900 °C to 1200 °C;
thereafter, forming a platinum-group metal layer (30) on the NiCoCrAlY layer (20); and
thereafter, forming an aluminide coating (34) over platinum-group metal layer (30).

2. The method as in claim 1, wherein the NiCoCrAlY layer (20) is heated to a treatment temperature of 1000 °C to 1100 °C.

3. The method as in either of claim 1 or 2, wherein the NiCoCrAlY layer (20) is heated to the treatment temperature for 30 minutes to 5 hours.

4. The method as in any preceding claim, wherein up to 30% of thickness of the NiCoCrAlY layer (20) diffuses into the surface (13) of the superalloy component (5).

5. The method as in claim 4, wherein 5% to 25% of thickness of the NiCoCrAlY layer (20) diffuses into the surface (13) of the superalloy component (5).

6. The method as in either of claim 4 or 5, wherein, after heat treatment, the NiCoCrAlY layer (20) has a thickness extending from the surface (13) of 10 µm to 100 µm while keeping the film holes (15) defined within the surface (13) of the superalloy component (5) open.

7. The method as in claim 6, wherein, after heat treatment, the NiCoCrAlY layer (20) has a thickness extending from the surface (13) of 25 µm to 50 µm while keeping the film holes (15) defined within the surface (13) of the superalloy component (5) open.

8. The method as in any preceding claim, wherein the NiCoCrAlY layer (20), prior to forming the platinum-group metal layer (30), has a composition comprising, by weight percent, 16% to 20% Cr, 9% to 11% Al, 19% to 24% Co, 0.05% to 0.2% Y, up to 0.5% Hf, up to 1% Si, and the balance Ni.

9. The method as in claim 8, wherein the NiCoCrAlY layer (20), prior to forming the platinum-group metal layer (30), has a composition comprising, by weight percent, 17% to 19% Cr, 9.5% to 10.5% Al, 21% to 23% Co, 0.07% to 0.15% Y, 0.05% to 0.3% Hf, 0.5% to 0.9% Si, and the balance Ni.

10. The method as in any preceding claim, further comprising:
after forming the platinum-group metal layer (30), heating the platinum-group metal layer (30) to a second heat treatment temperature of 900 °C to 1200 °C.

11. The method as in claim 10, further comprising:
after forming the platinum-group metal layer (30), heating the platinum-group metal layer (30) to a second heat treatment temperature of 1000 °C to 1100 °C.

12. The method as in any preceding claim, wherein the surface (13) of the superalloy component (5) defines a plurality of film holes (15) therein, and wherein the film holes (15) remain open after applying NiCoCrAlY on the surface (13) of the superalloy component (5) to form a NiCoCrAlY layer (20).

13. The method as in any preceding claim, wherein the aluminide coating (34) is deposited to a thickness of 25 µm to 100 µm.

14. The method as in any preceding claim, further comprising:
after forming the aluminide coating (34), forming a thermal barrier coating (36) over the bond coating.

15. The method as in any preceding claim, further comprising:
prior to applying the NiCoCrAlY on the surface (13), removing at least a portion of an existing coating system (22) on the surface (13) of the superalloy component (5).

## Patentansprüche

1. Verfahren zum Herstellen eines Beschichtungssystems (22) auf einer Oberfläche (13) einer Superlegierungs-Komponente (5), die mit darin definierten Filmlöchern (15) versehen ist, das Verfahren umfassend:
Aufbringen von NiCoCrAlY auf die Oberfläche (13) der Superlegierungs-Komponente (5) zur Bildung einer NiCoCrAlY-Schicht (20) unter Offenhalten der Filmlöcher (15), wobei die NiCoCrAlY-Schicht (20) einen höheren Chromgehalt als die Superlegierungs-Komponente (5) aufweist;
danach Erhitzen der NiCoCrAlY-Schicht (20) auf eine Behandlungstemperatur von 900 °C bis 1200 °C;
danach Ausbilden einer Platingruppen-Metallschicht (30) auf der NiCoCrAlY-Schicht (20); und danach Ausbilden einer Aluminidbeschichtung (34) über der Platingruppen-Metallschicht (30).

2. Verfahren nach Anspruch 1, wobei die NiCoCrAlY-Schicht (20) auf eine Behandlungstemperatur von 1000 °C bis 1100 °C erhitzt wird.

3. Verfahren nach einem der Ansprüche 1 oder 2, wobei die NiCoCrAlY-Schicht (20) für 30 Minuten bis 5 Stunden auf die Behandlungstemperatur erhitzt wird.

4. Verfahren nach einem der vorhergehenden Ansprüche, wobei bis zu 30 % der Dicke der NiCoCrAlY-Schicht (20) in die Oberfläche (13) der Superlegierungs-Komponente (5) diffundiert.

5. Verfahren nach Anspruch 4, wobei 5 % bis 25 % der Dicke der NiCoCrAlY-Schicht (20) in die Oberfläche (13) der Superlegierungs-Komponente (5) diffundiert.

6. Verfahren nach einem der Ansprüche 4 oder 5, wobei die NiCoCrAlY-Schicht (20) nach der Wärmebehandlung eine sich von der Oberfläche (13) erstreckende Dicke von 10 µm bis 100 µm aufweist, während die Filmlöcher (15), die innerhalb der Oberfläche (13) der Superlegierungs-Komponente (5) definiert sind, offen gehalten werden.

7. Verfahren nach Anspruch 6, wobei die NiCoCrAlY-Schicht (20) nach der Wärmebehandlung eine sich von der Oberfläche (13) erstreckende Dicke von 25 µm bis 50 µm aufweist, während die Filmlöcher (15), die innerhalb der Oberfläche (13) der Superlegierungs-Komponente (5) definiert sind, offen gehalten werden.

8. Verfahren nach einem der vorhergehenden Ansprüche, wobei die NiCoCrAlY-Schicht (20) vor der Bildung der Platingruppen-Metallschicht (30) eine Zusammensetzung aufweist, die in Gewichtsprozent 16 % bis 20 % Cr, 9 % bis 11 % AI, 19 % bis 24 % Co, 0,05 % bis 0,2 % Y, bis zu 0,5 % Hf, bis zu 1 % Si und der Rest Ni aufweist.

9. Verfahren nach Anspruch 8, wobei die NiCoCrAlY-Schicht (20) vor der Bildung der Platingruppen-Metallschicht (30) eine Zusammensetzung aufweist, die in Gewichtsprozent 17 % bis 19 % Cr, 9,5 % bis 10,5 % AI, 21 % bis 23 % Co, 0,07 % bis 0,15 % Y, 0,05 % bis 0,3 % Hf, 0,5 % bis 0,9 % Si und der Rest Ni aufweist.

10. Verfahren nach einem der vorhergehenden Ansprüche, ferner umfassend:
nach der Bildung der Platingruppen-Metallschicht (30) Erhitzen der Platingruppen-Metallschicht (30) auf eine zweite Wärmebehandlungs-Temperatur von 900 °C bis 1200 °C.

11. Verfahren nach Anspruch 10, ferner umfassend:
nach der Bildung der Platingruppen-Metallschicht (30) Erhitzen der Platingruppen-Metallschicht (30) auf eine zweite Wärmebehandlungs-Temperatur von 1000 °C bis 1100 °C.

12. Verfahren nach einem der vorhergehenden Ansprüche, wobei die Oberfläche (13) der Superlegierungs-Komponente (5) eine Vielzahl von Filmlöchern (15) darin definiert und wobei die Filmlöcher (15) nach dem Auftragen des NiCoCrAlY auf der Oberfläche (13) der Superlegierungs-Komponente (5) offen bleiben, um eine NiCoCrAlY-Schicht (20) zu bilden.

13. Verfahren nach einem der vorhergehenden Ansprüche, wobei die Aluminidbeschichtung (34) in einer Dicke von 25 µm bis 100 µm abgeschieden wird.

14. Verfahren nach einem der vorhergehenden Ansprüche, ferner umfassend:
nach der Bildung der Aluminidbeschichtung (34) das Bilden einer
Wärmesperrbeschichtung (36) über der Bindungsbeschichtung.

15. Verfahren nach einem der vorhergehenden Ansprüche, ferner umfassend:
vor dem Aufbringen des NiCoCrAlY auf der Oberfläche (13) das Entfernen mindestens eines Teils eines vorhandenen Beschichtungssystems (22) auf der Oberfläche (13) der Superlegierungs-Komponente (5) entfernt.

## Revendications

1. Procédé de formation d'un système de revêtement (22) sur une surface (13) d'un composant de superalliage (5) ayant des trous de film (15) définis dans celle-ci, le procédé comprenant :
l'application de NiCoCrAlY sur la surface (13) du composant de superalliage (5) pour former une couche de NiCoCrAlY (20) tout en conservant les trous de film (15) ouverts, la couche de NiCoCrAlY (20) ayant une teneur en chrome supérieure à celle du composant de superalliage (5) ;
puis, le chauffage de la couche de NiCoCrAlY (20) à une température de traitement de 900 °C à 1200 °C ;
puis, la formation d'une couche métallique du groupe du platine (30) sur la couche de NiCoCrAlY (20) ; et
puis, la formation d'un revêtement d'aluminure (34) sur une couche métallique du groupe du platine (30).

2. Procédé selon la revendication 1, dans lequel la couche de NiCoCrAlY (20) est chauffée à une température de traitement de 1 000 °C à 1 100 °C.

3. Procédé selon la revendication 1 ou 2, dans lequel la couche de NiCoCrAlY (20) est chauffée à la température de traitement pendant 30 minutes à 5 heures.

4. Procédé selon l'une quelconque des revendications précédentes, dans lequel jusqu'à 30 % d'épaisseur de la couche de NiCoCrAlY (20) se diffuse dans la surface (13) du composant de superalliage (5).

5. Procédé selon la revendication 4, dans lequel 5 % à 25 % d'épaisseur de la couche de NiCoCrAlY (20) se diffuse dans la surface (13) du composant de superalliage (5).

6. Procédé selon l'une des revendications 4 ou 5, dans lequel, après traitement thermique, la couche de NiCoCrAlY (20) a une épaisseur s'étendant depuis la surface (13) de 10 µm à 100 µm tout en conservant les trous de film (15) définis à l'intérieur de la surface (13) du composant de superalliage (5) ouvert.

7. Procédé selon la revendication 6, dans lequel, après traitement thermique, la couche de NiCoCrAlY (20) a une épaisseur s'étendant depuis la surface (13) de 25 µm à 50 µm tout en conservant les trous de film (15) définis à l'intérieur de la surface (13) du composant de superalliage (5) ouvert.

8. Procédé selon l'une quelconque des revendications précédentes, dans lequel la couche de NiCoCrAlY (20), avant de former la couche métallique du groupe du platine (30), a une composition comprenant, en pourcentage en poids, 16 % à 20 % de Cr, 9 % à 11 % d'AI, 19 % à 24 % de Co, 0,05 % à 0,2 % de Y, jusqu'à 0,5 % de Hf, jusqu'à 1 % de Si et le reste de Ni.

9. Procédé selon la revendication 8, dans lequel la couche de NiCoCrAlY (20), avant de former la couche métallique du groupe du platine (30), a une composition comprenant, en pourcentage en poids, 17 % à 19 % de Cr, 9,5 % à 10,5 % d'AI, 21 % à 23 % de Co, 0,07 % à 0,15 % de Y, 0,05 % à 0,3 % de Hf, 0,5 % à 0,9 % de Si et le reste de Ni.

10. Procédé selon l'une quelconque des revendications précédentes, comprenant en outre :
après la formation de la couche métallique du groupe du platine (30), le chauffage de la couche métallique du groupe du platine (30) à une seconde température de traitement thermique de 900 °C à 1 200 °C.

11. Procédé selon la revendication 10, comprenant en outre :
après la formation de la couche métallique du groupe du platine (30), le chauffage de la couche métallique du groupe du platine (30) à une seconde température de traitement thermique de 1 000 °C à 1 100 °C.

12. Procédé selon l'une quelconque des revendications précédentes, dans lequel la surface (13) du composant de superalliage (5) définit une pluralité de trous de film (15) dans celle-ci, les trous de film (15) restant ouverts après l'application de NiCoCrAlY sur la surface (13) du composant de superalliage (5) pour former une couche de NiCoCrAlY (20).

13. Procédé selon l'une quelconque des revendications précédentes, dans lequel le revêtement d'aluminure (34) est déposé sur une épaisseur de 25 µm à 100 µm.

14. Procédé selon l'une quelconque des revendications précédentes, comprenant en outre :
après la formation du revêtement d'aluminure (34), la formation d'un revêtement de barrière thermique (36) sur le revêtement de liaison.

15. Procédé selon l'une quelconque des revendications précédentes, comprenant en outre :
avant l'application du NiCoCrAlY sur la surface (13), le retrait d'au moins une partie d'un système de revêtement existant (22) sur la surface (13) du composant de superalliage (5).
